# DEMANDE DE BREVET EUROPEEN

(11) **EP 4 491 273 A1**
(43) Date de publication de la demande: **15.01.2025**
(21) Numéro de dépôt: 24178899.1
(22) Date de dépôt: 29.05.2024
(51) Int. Cl.: B01L 3/00, B81B 3/00, C12M 1/00, G01N 15/00, G01N 29/00, G01N 29/02, G01N 29/036

(54) **SYSTÈME D'ANALYSE D'UN FLUIDE INCLUANT UN COMPOSANT GÉNÉRATEUR D ONDES ACOUSTIQUES**

(30) Priorité: 12.07.2023 FR 2307454
(71) Demandeur: Commissariat à l'Energie Atomique et aux Energies Alternatives, 75015 Paris (FR)
(72) Inventeur: ALDRIN, Katell, 38054 Grenoble cedex 09 (FR); AGACHE, Vincent, 38054 Grenoble cedex 09 (FR); LEPOETRE, Aurélien, 38054 Grenoble cedex 09 (FR)
(74) Mandataire: INNOV-GROUP

(57) **Abrégé**

L'invention concerne un système d'analyse d'un fluide comprenant :
- Un composant microfluidique (1) intégrant un circuit microfluidique principal (10) et comportant une face avant (12) et une face arrière (13),
- Un composant de mesure/analyse (2) monté sur la face avant (12) du composant micofluidique (1) et qui comporte au moins un organe de mesure (21) apte à être stimulé mécaniquement par des ondes acoustiques,
- Un composant générateur d'ondes acoustiques,
- Le composant générateur d'ondes acoustiques étant monté sur la face arrière (13) du composant microfluidique (1).

## Description

### Domaine technique de l'invention

La présente invention se rapporte à un système d'analyse d'un fluide.

### Etat de la technique

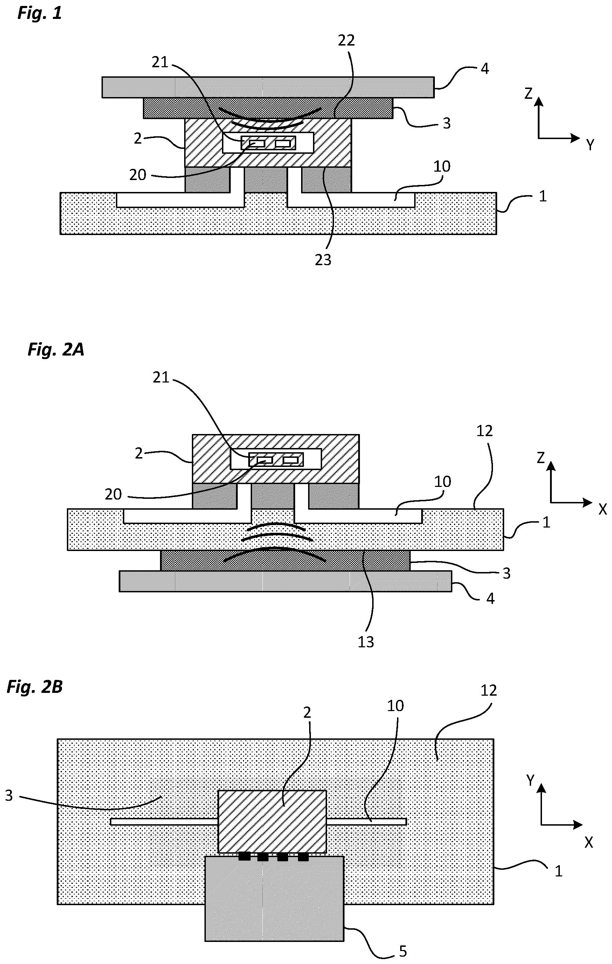

En référence à la figure 1, dans le domaine de l'analyse fluidique, il est connu de venir connecter un composant de mesure/analyse 2 sur un composant microfluidique 1 (appelé également interposeur microfluidique, dans le sens où il accueille le composant de mesure/analyse 2). Le composant microfluidique 1 est souvent réalisé dans un matériau polymère transparent et intègre un circuit microfluidique principal 10 formé de canaux microfluidiques dans lequel circule un fluide à analyser lui-même ou véhiculant des particules à analyser. Le composant de mesure/analyse 2 comporte un circuit microfluidique de mesure 20 connecté au circuit microfluidique principal du composant microfluidique et un organe de mesure 21 apte à être stimulé mécaniquement par des ondes acoustiques. Ce type de composant de mesure/analyse est très souvent réalisé sous la forme d'une puce MEMS ("Micro-ElectroMechanical System") ou NEMS ("Nano-ElectroMechanical System").

Pour générer les ondes acoustiques, il est classique d'utiliser un système d'actionnement. Plusieurs types de systèmes d'actionnement peuvent être envisagés, fonctionnant notamment par couplage capacitif ou par actionnement piézoélectrique. Un actionnement piézoélectrique est réalisé en utilisant un élément piézoélectrique fabriqué sous la forme d'une céramique. L'élément d'actionnement est alors appelé élément piézocéramique 3.

Pour coupler le composant de mesure/analyse 2 avec le composant microfluidique 1, il faut :
- Réaliser la connexion fluidique entre le circuit microfluidique 10 principal et le circuit microfluidique 20 de mesure en vue de pouvoir assurer le transfert de fluide ;
- Réaliser les connexions électriques du composant de mesure/analyse 2 afin de lire le signal électrique généré ;
- Réaliser un actionnement mécanique de l'organe de mesure 21 du composant de mesure/analyse 2 ;

Dans le cas où l'on souhaite connecter le composant de mesure/analyse 2 sur le composant microfluidique 1, la face arrière 23 du composant de mesure/analyse 2 est dédiée à la connexion fluidique, tandis que sa face avant 22 est dédiée à la connexion électrique. Comme représenté sur la figure 1, pour actionner le composant de mesure/analyse 2, on vient classiquement mettre l'élément piézocéramique 3 en contact direct avec le composant de mesure/analyse 2 en le montant sur sa face avant 22. Cependant, dans cette configuration, l'élément piézocéramique 3 qui est opaque vient empêcher une visualisation directe des zones d'intérêt à l'intérieur des circuits fluidiques pendant l'expérience, et vient aussi complexifier grandement la manipulation et la connexion de la puce, notamment pour y réaliser les connexions électriques.

La demande de brevet US2017/106134A1 décrit un système pour manipuler et trier des particules.

Il existe un besoin d'obtenir un système d'analyse incluant un composant microfluidique et un composant de mesure/analyse à actionnement par ondes acoustiques qui :
- Assure une visualisation des circuits fluidiques intégrés aux composants ;
- Evite tout risque de court-circuit entre les fils de connexion électrique venant se connecter sur le composant de mesure/analyse et le composant générateur d'ondes acoustiques lorsqu'il est par exemple réalisé dans une piézocéramique ;
- Evite tout risque de dommages au niveau des fils de connexion électrique ;

### Exposé de l'invention

Ce but est atteint par un système d'analyse d'un fluide comprenant :
- Un composant microfluidique défini avec une face dite avant et une face dite arrière, opposée à la face avant et séparée de celle-ci par l'épaisseur du composant microfluidique, ledit composant microfluidique comportant un circuit microfluidique principal intégré dans son épaisseur,
- Un composant de mesure/analyse monté sur la face avant du composant micofluidique (1) et qui comporte au moins un organe de mesure apte à être stimulé mécaniquement par des ondes acoustiques,
- Un composant générateur d'ondes acoustiques apte à générer les ondes acoustiques de stimulation dudit organe de mesure,
- Le composant générateur d'ondes acoustiques étant monté sur la face arrière du composant microfluidique.

Selon une particularité, le composant de mesure/analyse est un résonateur de type MEMS/NEMS comprenant un circuit microfluidique de mesure connecté sur le circuit microfluidique principal du composant microfluidique.

Selon une autre particularité, le composant générateur d'ondes acoustiques est un composant piézoélectrique.

Selon une autre particularité, le composant piézoélectrique est un élément piézocéramique.

Selon une autre particularité, l'élément piézocéramique présente un encombrement en deux dimensions formant une surface projetée dans laquelle est inscrite le composant de mesure/analyse.

Selon une autre particularité, le composant de mesure/analyse est centrée sur la surface projetée de l'élément piézocéramique.

Selon une réalisation particulière, le système comporte plusieurs organes de mesure juxtaposés, actionnables par un unique composant générateur d'ondes acoustiques. Selon une autre particularité, le composant microfluidique est réalisé dans un matériau polymère.

Selon une autre particularité, le composant microfluidique est réalisé en Cyclo-Oléfine Copolymère ou en Polyméthacrylate de Méthyle.

Selon une autre particularité, le système comporte une carte électronique de commande sur laquelle est monté le composant générateur d'ondes acoustiques.

Selon une autre particularité, le système comporte une carte électronique de mesure montée sur la face avant du composant microfluidique, portant une unité de lecture et des contacts électriques reliant ladite unité de lecture au composant de mesure/analyse.

Il faut noter que l'architecture du système est telle que les trois composants sont en contact physique les uns avec les autres, formant un empilement.

Le composant de mesure/analyse et le composant générateur d'ondes acoustiques sont donc agencés de part et d'autre du composant microfluidique, ce qui n'empêche pas la transmission des ondes acoustiques à travers le composant microfluidique, alors même que ce dernier est souvent réalisé dans un matériau de type polymère (COC ou PMMA par exemple), matériau qui serait pourtant susceptible d'atténuer la transmission des ondes acoustiques et que celui-ci intègre un réseau fluidique.

### Brève description des figures

D'autres caractéristiques et avantages vont apparaître dans la description détaillée en liaison avec les figures annexées listées ci-dessous :
- La figure 1 représente une architecture d'un système d'analyse d'un fluide conforme à l'état de la technique ;
- Les figures 2A et 2B représentent une architecture d'un système d'analyse d'un fluide conforme à l'invention, respectivement vu en coupe et en vue de dessus par transparence ;
- La figure 3 représente un système selon une variante de réalisation avec plusieurs oscillateurs avec un actionnement commun ;
- La figure 4 représente un diagramme montrant la réponse fréquentielle de l'amplitude d'oscillation d'un composant de mesure/analyse de type SNR dans différentes configurations d'empilement ;
- La figure 5 représente un diagramme montrant la limite de détection en masse obtenue en fonction du temps d'intégration, par la mesure de la variance d'Allan pour différentes architectures d'actionnement ;
- La figure 6 montre un exemple de montage de l'élément piézocéramique employé dans le système de l'invention ;

### Description détaillée d'au moins un mode de réalisation

Le système de l'invention est destiné à l'analyse d'un fluide ou de particules véhiculées par le fluide en utilisant la microfluidique. Pour rappel, la microfluidique consiste à manipuler des fluides en très faible volume (typiquement du µL au pL) de manière contrôlée. Cette manipulation est effectuée dans un composant microfluidique.

Grâce au système de l'invention, il est par exemple possible de caractériser au moins une propriété (par exemple la masse, le volume, la densité) d'une particule. Par particule, on entend par exemple une particule biologique telle que cellule, exosome, virus, bactérie... On entend également par particule, une particule de type inorganique telle que par exemple une particule d'Or, de Polystyrène, de Silice...

Pour la suite de la description, on définit un repère orthonormé (X, Y, Z) afin de matérialiser les trois dimensions.

### Composant microfluidique

### Figure 2A et Figure 2B

Le composant microfluidique 1 peut également être appelé puce microfluidique, carte microfluidique, interposeur microfluidique ou cartouche microfluidique. Il se présente ainsi sous la forme d'un support généralement plat ou peu épais dans le sens de la hauteur (selon l'axe Z) au regard de ses deux autres dimensions. Il peut être composé d'un assemblage de plusieurs couches scellées entre elles. Avantageusement, Il présente une forme rectangulaire dans ses deux dimensions X et Y et dispose d'une épaisseur constante suivant Z.

Le composant microfluidique 1 est défini avec une face dite avant 12 et une face dite arrière 13, opposée à la face avant et séparée de celle-ci par l'épaisseur du composant microfluidique. Les deux faces avant et arrière s'étendent chacune suivant les deux axes X et Y et sont avantageusement planes, perpendiculaires à l'axe Z.

Le composant microfluidique 1 comporte un circuit microfluidique dit circuit microfluidique principal 10 intégré dans son épaisseur. Ce circuit microfluidique principal 10 peut présenter des canaux microfluidiques de quelques micromètres, ayant par exemple une section transversale carrée. De manière non limitative, le circuit microfluidique principal 10 peut également comporter des pompes fluidiques, des vannes fluidiques, des réservoirs ou autres éléments fluidiques (non représentés) permettant de faire circuler le fluide dans le circuit microfluidique principal 10.

Le composant microfluidique 1 peut notamment intégrer une membrane déformable (type "Ecoflex") formant l'une des couches du composant microfluidique 1, cette membrane étant déployable pour réaliser une fonction d'un élément fluidique telle que par exemple pompage, vanne...

Le composant microfluidique 1 peut être fabriqué dans plusieurs types de matériaux, majoritairement de type polymère tels que par exemple le COC (Cyclo-Oléfine Copolymère) ou le PMMA (Polyméthacrylate de Méthyle).

### Composant de Mesure/Analyse

### Figure 2A et Figure 2B

Le système de mesure/analyse de l'invention comporte également un composant de mesure/analyse 2 monté sur le composant microfluidique 1. Autrement dit, le composant de mesure/analyse 2 est fixé sur le composant microfluidique 1, sur sa face avant 12, et vient en contact physique contre cette face avant 12. La mise au contact peut s'effectuer par contact direct, ou avantageusement via un ou plusieurs joints percés au niveau des accès fluidiques et un système de serrage mécanique pour assurer l'étanchéité. Alternativement de la colle peut être employée comme interface de collage localisée entre le composant de mesure/analyse 2 et sur le composant microfluidique 1, à l'exception des zones d'accès fluidiques pour ne pas les obstruer.

Le composant de mesure/analyse 2 comporte un circuit microfluidique dit de mesure 20 venant se connecter fluidiquement au circuit microfluidique principal 10 lorsque le composant de mesure/analyse 2 est monté sur la face avant 12 du composant microfluidique 1.

Le composant de mesure/analyse 2 est par exemple un oscillateur mécanique.

Le composant de mesure/analyse 2 comporte ainsi un organe de mesure 21 apte à être excité mécaniquement par des ondes acoustiques. Cet organe de mesure 21 peut être constitué d'une poutre apte à être mise en vibration lorsqu'elle est excitée.

A titre d'exemple, l'oscillateur mécanique peut être un résonateur de type SMR/SNR (pour "Suspended Microchannel Resonator" et "Suspended Nanochannel Resonator") utilisé par exemple pour la pesée de nano ou microparticules (inorganiques, ou biologiques).

Un résonateur mécanique 1 (SMR ou SNR) comporte au moins une partie fixe, et une partie suspendue, formant l'organe de mesure 21, reliée à la partie fixe et capable de vibrer lorsqu'elle est excitée. Il comporte également le circuit microfluidique de mesure 20 intégré à sa partie suspendue, ce circuit microfluidique comprenant au moins un canal fluidique creusé à l'intérieur de sa partie suspendue, recouvert de parois étanches sur les quatre faces (dessus, dessous, latéralement) et destiné à être utilisé pour y injecter un fluide dans lequel sont par exemple placées une ou plusieurs particules à caractériser.

La partie suspendue est excitée par des moyens externes, à la fréquence de résonance ou à une fréquence d'un mode propre supérieur. Dans ce type de résonateur, la vibration est généralement réalisée hors plan, mais alternativement elle peut être générée dans le plan, ou encore en torsion.

Le composant de mesure/analyse 2 se présente avantageusement sous la forme d'un prisme droit, par exemple un parallélépipède (une puce dans le langage électronique). Il est monté dans un logement adapté réalisé sur la face avant du composant microfluidique 1.

Le composant de mesure/analyse 2 peut comporter des contacts électriques sur lesquels vient se connecter une unité de lecture chargée de lire les signaux électriques générés par le composant de mesure/analyse lorsqu'il est excité. L'unité de lecture peut être réalisée sur une carte électronique 5 (PCB - "Printed Circuit Board" - visible figure 2B en vue de dessus), les contacts électriques du composant de mesure/analyse 2 étant connectés à des plots électriques de l'unité de lecture assemblée sur la carte 5, par exemple via des fils de connexion électrique. Cette carte électronique 5 peut être une carte électronique dédiée, distincte de celle utilisée pour la commande de l'élément piézocéramique 3.

L'organe de mesure 21 du composant de mesure/analyse 2 est apte à être excité à l'aide d'ondes acoustiques, créées par un composant générateur d'ondes acoustiques.

### Composant générateur d'ondes acoustiques

### Figure 2A et Figure 2B

Le composant générateur d'ondes acoustiques est un composant piézoélectrique. Il est avantageusement réalisé sous la forme d'un élément piézocéramique 3. Il pourrait également s'agir d'un dispositif de type SAW (pour "Surface Acoustic Wave") ou PMUT (pour "Piezoelectric Micromachined Ultrasonic Transducer").

Le composant générateur d'ondes acoustiques comporte des connexions électriques pour recevoir des impulsions électriques de commande et est ainsi configuré pour générer les ondes acoustiques souhaitées.

L'élément piézocéramique 3 se présente par exemple sous la forme d'une plaque rectangulaire comportant des pattes de contact électrique.

Sur la figure 2B, l'élément piézocéramique 3 est montré en transparence. Il faut comprendre qu'il est positionné sous le composant microfluidique 1.

Une unité de commande est associée à l'élément piézocéramique 3. Elle est par exemple réalisée sur une carte électronique 4 montée sur la face arrière de l'élément piézocéramique 3.

### Empilement des composants

### Figure 2A et Figure 2B

Selon l'invention, le système est configuré de manière à former un empilement suivant l'axe Z. Dans cet empilement, on a :
- Le composant microfluidique 1 qui dispose de sa face arrière 13 et de sa face avant 12 ;
- Le composant de mesure/analyse 2 monté sur la face avant 12 du composant microfluidique 1, de manière à venir en contact avec celle-ci. Le circuit microfluidique de mesure 20 est connecté fluidiquement au circuit microfluidique principal 10 du composant microfluidique 1 ;
- Le composant générateur d'ondes acoustiques, par exemple formé de l'élément piézocéramique 3, monté sur la face arrière 13 du composant microfluidique 1 ;

Le système peut également comporter la carte électronique 4 présentant une face avant sur laquelle est soudé l'élément piézocéramique 3 et la carte électronique 5 dédiée à la lecture des signaux émanant du composant de mesure/analyse 2.

De manière avantageuse, le composant générateur d'ondes acoustiques présente un encombrement dans les deux dimensions X et Y formant une surface projetée suivant l'axe Z. Le composant de mesure/analyse 2 dispose également d'un encombrement dans les deux dimensions X et Y dont la surface est incluse dans la surface projetée du composant générateur d'ondes acoustiques.

De manière avantageuse également, le composant de mesure/analyse 2 est centré par rapport au composant générateur d'ondes acoustiques et présente un encombrement suivant les dimensions X et Y inférieur à celui du composant générateur d'ondes acoustiques.

### Réalisation particulière

### Figure 2A, Figure 2B et Figure 6.

De manière expérimentale, on a réalisé un premier prototype du système, incluant un composant microfluidique 1, un oscillateur mécanique de type SNR (réalisé sous la forme d'une puce SNR) monté sur la face avant 12 du composant microfluidique 1 pour jouer le rôle du composant de mesure/analyse 2 et un élément piézocéramique 3 monté sur la face arrière 13 du composant microfluidique 1 et jouant le rôle du composant générateur d'ondes acoustiques.

Le composant microfluidique 1 se présente sous la forme d'une plaque ou carte réalisée dans un polymère plastique de type COC (Cyclo-Oléfine Copolymère) ou PMMA (Polyméthacrylate de Méthyle Acrylique), qui est usinée à l'aide d'une machine d'usinage de précision. L'usinage de cette pièce se fait sur les deux faces :
- Sur la face arrière 13 pour dessiner les canaux microfluidiques du circuit microfluidique principal 10 qui seront ensuite refermés à l'aide d'un film adhésif (par exemple de type "MicroAmp") ;
- Sur la face avant 12, pour réaliser les logements permettant d'accueillir la puce SNR et la carte électronique 5 permettant la lecture du signal de la puce SNR ;

La plaque en plastique contient avantageusement plusieurs trous permettant d'accueillir des vis, d'une part pour assurer la connexion fluidique étanche à l'aide de joints souples et d'autre part pour assurer le maintien de l'élément piézocéramique 3 au contact de la face arrière 13 du composant microfluidique 1.

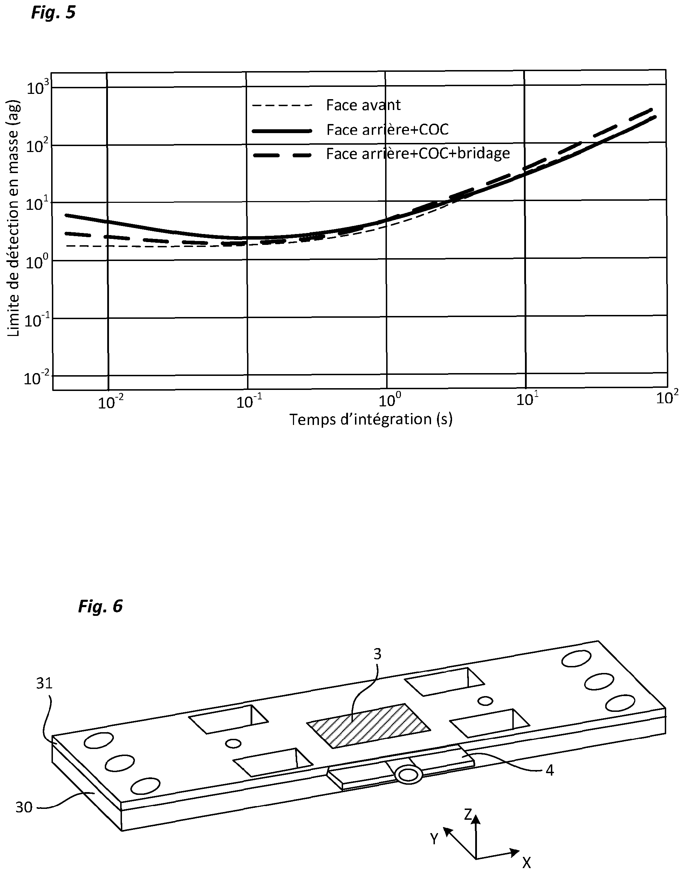

En référence à la figure 6, deux pièces 30, 31 supplémentaires sont par exemple également usinées en plastique de type COC ou PMMA, et sont intégrées au système pour maintenir l'élément piézocéramique 3 en contact physique avec la face arrière 13 du composant microfluidique 1, à l'emplacement souhaité. L'élément piézocéramique 3 est alors pris en sandwich entre ces deux pièces 30, 31, vissées l'une à l'autre. L'assemblage entre ces deux pièces en contact offrent notamment un logement pour la carte électronique 4 dédiée à la commande de l'élément piézocéramique 3.

Une fois les pièces préparées, il est nécessaire d'assurer les connexions électriques permettant la lecture du signal de la puce SNR. Pour ce faire, on peut procéder à une étape de "wire bonding" (ou soudure par fil), permettant de connecter électriquement les contacts métalliques de la puce SNR avec les contacts métalliques de la carte électronique 5 de lecture. La connexion fluidique est ensuite établie pour permettre la circulation de fluides à l'intérieur du composant microfluidique 1 et au sein de la puce SNR.

Il est également possible d'assurer un contact ferme entre la puce SNR et le composant microfluidique 1 à l'aide d'une pièce de serrage (non représentée), vissée de part et d'autre de la puce SNR, pour la maintenir en place. Cette pièce usinée en plastique transparent et pouvant éventuellement contenir un trou d'observation, ne gêne alors pas la visualisation des parties d'intérêt de la puce MEMS.

### Expérimentation

### Figure 4 et Figure 5.

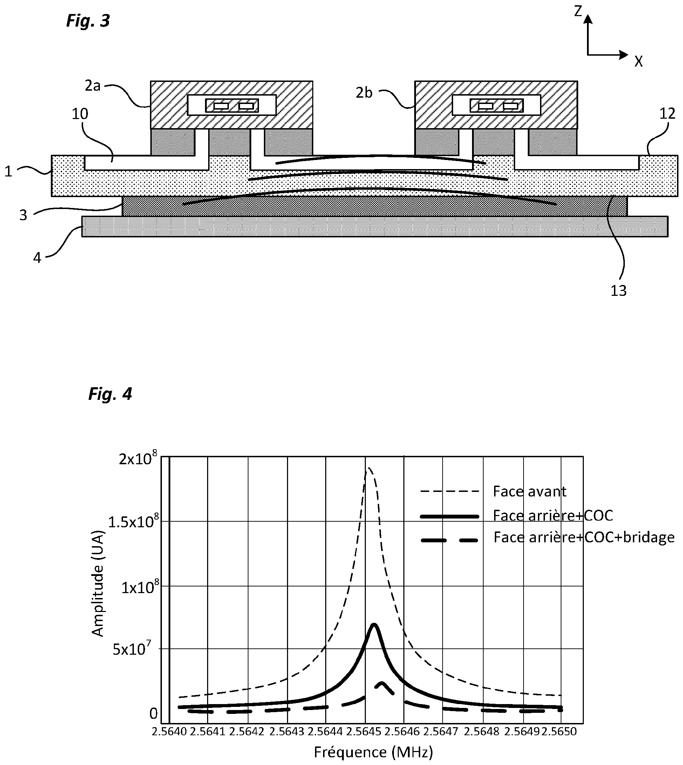

Afin de tester le bon fonctionnement du système, le protocole consiste à tester la réponse fréquentielle de la puce SNR lorsque le circuit microfluidique principal 10 est empli d'air. On effectue alors un balayage fréquentiel pour connaître la fréquence de résonance de la puce SNR et son facteur de qualité. On peut ainsi observer que les ondes générées par l'élément piézocéramique sont bien transmises à la puce SNR à travers le support en COC formé par le composant microfluidique 1. Il faut cependant noter une baisse d'amplitude modérée (moins d'un ordre de grandeur) de la réponse comparativement à celle obtenue lorsque l'élément piézocéramique est directement monté sur la puce SNR (figure 4).

Cela peut s'expliquer de trois façons :
- La transmission des ondes mécaniques se fait à travers une épaisseur supplémentaire (celle du composant microfluidique), ce qui engendre une dissipation des ondes et donc une légère baisse d'efficacité de l'actionnement.
- Les canaux microfluidiques étant creux et non remplis, situés directement sous la puce SNR, la transmission des ondes mécaniques est moins importante.
- Le contact mécanique entre la puce SNR et le composant microfluidique est ici assuré par un simple adhésif double face, ce qui peut contribuer à dissiper une partie des ondes.

Cependant, le facteur de qualité, indice de performance, ne semble pas affecté négativement par le fait d'actionner la puce SNR à travers le composant microfluidique.

On actionne ensuite la puce SNR en boucle fermée (c'est-à-dire que sa fréquence de résonance est lue en continu et le signal appliqué à l'élément piézocéramique 3 est constamment mis à jour en fonction des fluctuations de fréquence éventuelles).

On réalise une expérience dite de "variance d'Allan", afin d'obtenir le bruit fréquentiel moyen de la puce SNR, que l'on traduit ensuite en limite de détection en masse. A l'issue de 10 minutes d'acquisition des données de bruit fréquentiel, il est ensuite possible de calculer la variance d'Allan de la puce SNR, valeur qui permet d'obtenir une estimation de la limite basse de détection en masse de la puce, en fonction du temps d'intégration de la boucle d'asservissement. Cette limite de détection dépend de nombreux facteurs, et notamment de l'efficacité d'actionnement de la puce. Cette expérience est effectuée en appliquant la même tension d'actionnement sur la piézocéramique, pour un actionnement en contact direct avec la puce SNR (selon l'état de la technique-figure 1) et un actionnement déporté à travers le composant microfluidique selon l'invention.

En référence au diagramme de la figure 5, on constate que la variance d'Allan est similaire pour toutes les architectures testées, et on note une très faible modification de la limite de détection en masse lorsque la puce SNR est actionnée à travers le composant microfluidique selon l'architecture de l'invention.

Sur les figures 4 et 5, on tient également compte d'une architecture dans laquelle l'élément piézocéramique 3 est en face arrière 13 et le système comporte un dispositif de bridage pour venir maintenir l'empilement en place.

### Système de mesure/analyse

### Figure 3.

Il est également possible d'utiliser le principe de l'invention sur un système complet d'analyse dans lequel un unique composant générateur d'ondes acoustiques (par exemple un unique élément piézocéramique 3) est monté sur la face arrière 13 d'un même composant microfluidique 1 pour actionner plusieurs oscillateurs fabriqués sur une même puce ou sur plusieurs puces 2a, 2b distinctes juxtaposées, montées sur la face avant 12 du composant microfluidique 1.

Dans cette configuration, la puce ou les puces 2a, 2b montées sur la face avant 12 du composant microfluidique 1 sont agencées de sorte à être placées dans la surface projetée du composant générateur d'ondes acoustiques afin que tous les oscillateurs puissent être actionnables par un même élément piézocéramique 3.

Il est en effet possible d'actionner plusieurs oscillateurs par le biais d'un seul élément piézocéramique 3, à condition que la fréquence de résonance de chaque oscillateur soit suffisamment différenciée des autres, et que leur facteur de qualité soit suffisamment élevé pour que l'actionnement d'un oscillateur ne vienne pas perturber un autre oscillateur juxtaposé, et qu'il n'y ait pas de diaphonie entre ces oscillateurs, si jamais leur fréquence de résonance respective était trop proche l'une de l'autre.

Ce système présente plusieurs avantages. Il est en effet possible de :
- Effectuer plusieurs analyses en parallèle d'un même échantillon, sur un même composant microfluidique 1 ;
- Tester l'influence de plusieurs conditions de traitement d'un même échantillon.

Par ailleurs, comme déjà indiqué ci-dessus, le composant microfluidique 1 peut disposer d'une architecture complexe avec des éléments fluidiques tels que pompes, vannes, réservoirs, actionnables par exemple par une membrane intégrée dans l'empilement de couches du composant microfluidique. Ce type d'architecture est notamment décrit dans la publication référencée ci-dessous :
C. Parent, F. Boizot, M. Cubizolles, N. Verplanck, J.-L. Achard, Y. Fouillet, Quantitative biological assays with on-chip calibration using versatile architecture and collapsible chambers, Sensors and Actuators B: Chemical, Volume 261, 2018, Pages 106-114,ISSN 0925-4005, https://doi.org/10.1016/j.snb.2018.01.111.

La solution de l'invention permet ainsi d'actionner à distance un composant de mesure/analyse 2 sensible aux ondes acoustiques monté sur la face avant 12 d'un composant microfluidique 1 en mettant en contact, contre la face arrière 13 du composant microfluidique, un composant générateur d'ondes acoustiques adapté, commandé pour émettre les ondes acoustiques. Ce principe s'applique même lorsque les canaux microfluidiques du circuit microfluidique principal 10 sont vides.

Par cette configuration, il est possible de poursuivre l'observation du circuit microfluidique principal, de faciliter les connexions électriques des composants et d'implémenter plusieurs puces de mesure/analyse distinctes juxtaposées, montées sur la face avant d'un composant microfluidique unique.

## Revendications

1. Système d'analyse d'un fluide comprenant :
- Un composant microfluidique (1) défini avec une face dite avant (12) et une face dite arrière (13), opposée à la face avant et séparée de celle-ci par l'épaisseur du composant microfluidique, ledit composant microfluidique comportant un circuit microfluidique principal (10) intégré dans son épaisseur,
- Un composant de mesure/analyse (2) monté sur la face avant (12) du composant micofluidique (1) et qui comporte au moins un organe de mesure (21) apte à être stimulé mécaniquement par des ondes acoustiques,
- Un composant générateur d'ondes acoustiques apte à générer les ondes acoustiques de stimulation dudit organe de mesure (21),
- **Caractérisé en ce que** le composant générateur d'ondes acoustiques est monté sur la face arrière (13) du composant microfluidique (1).

2. Système selon la revendication 1, **caractérisé en ce que** le composant de mesure/analyse (2) est un résonateur de type MEMS/NEMS comprenant un circuit microfluidique de mesure (20) connecté sur le circuit microfluidique principal (10) du composant microfluidique (1).

3. Système selon la revendication 1 ou 2, **caractérisé en ce que** le composant générateur d'ondes acoustiques est un composant piézoélectrique.

4. Système selon la revendication 3, **caractérisé en ce que** le composant piézoélectrique est un élément piézocéramique (3).

5. Système selon la revendication 4, **caractérisé en ce que** l'élément piézocéramique (3) présente un encombrement en deux dimensions formant une surface projetée dans laquelle est inscrite le composant de mesure/analyse (2).

6. Système selon la revendication 5, **caractérisé en ce que** le composant de mesure/analyse (2) est centrée sur la surface projetée de l'élément piézocéramique.

7. Système selon l'une des revendications 1 à 6, **caractérisé en ce qu'**il comporte plusieurs organes de mesure juxtaposés, actionnables par un unique composant générateur d'ondes acoustiques.

8. Système selon l'une des revendications 1 à 7, **caractérisé en ce que** le composant microfluidique (1) est réalisé dans un matériau polymère.

9. Système selon la revendication 8, **caractérisé en ce que** le composant microfluidique (1) est réalisé en Cyclo-Oléfine Copolymère ou en Polyméthacrylate de Méthyle.

10. Système selon l'une des revendications 1 à 9, **caractérisé en ce qu'**il comporte une carte électronique (4) de commande sur laquelle est monté le composant générateur d'ondes acoustiques.

11. Système selon l'une des revendications 1 à 10, **caractérisé en ce qu'**il comporte une carte électronique (5) de mesure montée sur la face avant (12) du composant microfluidique, portant une unité de lecture et des contacts électriques reliant ladite unité de lecture au composant de mesure/analyse (2).
